# EUROPEAN PATENT SPECIFICATION

(11) **EP 3 736 316 B1**
(45) Date of publication and mention of the grant of the patent: **29.03.2023**
(21) Application number: 20156353.3
(22) Date of filing: 10.02.2020
(51) Int. Cl.: C09K 11/80, C30B 29/22, C30B 15/08, H01L 33/50

(54) **PHOSPHOR AND LIGHT SOURCE DEVICE**
LEUCHTSTOFF UND LICHTQUELLENVORRICHTUNG
LUMINOPHORE ET DISPOSITIF DE SOURCE LUMINEUSE

(30) Priority: 13.02.2019 JP 2019023586
(43) Date of publication of application: 11.11.2020
(73) Proprietor: TDK Corporation, Tokyo 103-6128 (JP)
(72) Inventor: TERUI, Tatsuya, Tokyo, 103-6128 (JP); UMEDA, Yuji, Tokyo, 103-6128 (JP)
(74) Representative: Epping - Hermann - Fischer

(56) References cited:
- US-A1- 2008 298 407
- US-A1- 2010 226 407
- US-A1- 2017 145 307
- FUKABORI A ET AL: "Study on the single crystal growth of concentration gradient Ce:YAP rod and the dopant concentration dependence on the scintillation properties", RADIATION MEASUREMENTS, ELSEVIER, AMSTERDAM, NL, vol. 45, no. 3-6, 1 March 2010 (2010-03-01), pages 453-456, XP027064403, ISSN: 1350-4487, DOI: 10.1016/J.RADMEAS.2009.11.025 [retrieved on 2009-11-18]

## Description

### BACKGROUND OF THE INVENTION

### 1. Field of the Invention

The present invention relates to a phosphor and a light source device using the phosphor.

### 2. Description of the Related Art

Applications of phosphors as color tone conversion materials for high-intensity lighting such as vehicle lighting and high-output projectors are being studied.

In these applications, a high-output LED or laser is used as an excitation light source, and thus the surface temperature of the phosphor as a light receiving unit is likely to increase.

The transparent polycrystalline ceramic that is described in JP 2010-24278 A has problems in that a "thermal quenching" phenomenon in which the luminous efficiency decreases at a high temperature occurs.
A phosphor which comprises Yb as an additive in a constant and homogenously distributed concentration is disclosed in US 2010/226407 A1.

### SUMMARY OF THE INVENTION

The invention has been made in view of the above problems, and an object of the invention is to provide a phosphor having high thermal conductivity and high light emission characteristics and a light source device having the phosphor.

The invention is set out in the appended set of claims.

### BRIEF DESCRIPTION OF THE DRAWINGS

Fig. 1 is a perspective view of a phosphor according to an embodiment of the invention;
Fig. 2 is a cross-sectional view of the phosphor taken along line II-II illustrated in Fig. 1;
Fig. 3A is a cross-sectional view of the phosphor taken along line IIIA-IIIA illustrated in Fig. 1;
Fig. 3B is a modification example of the cross-sectional view of the phosphor illustrated in Fig. 3A;
Fig. 4 is a schematic cross-sectional view of a single crystal manufacturing apparatus for manufacturing the phosphor according to an embodiment of the invention;
Fig. 5 is a perspective view of a phosphor according to another embodiment of the invention;
Fig. 6 is a cross-sectional view of the phosphor taken along line VI-VI illustrated in Fig. 5;
Fig. 7 is a cross-sectional view of the phosphor taken along line VII-VII illustrated in Fig. 5;

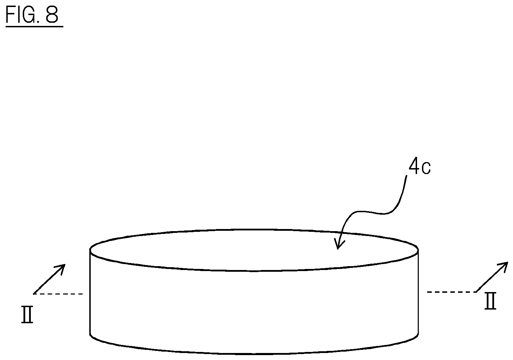

Fig. 8 is a perspective view of a phosphor according to another embodiment of the invention;
Fig. 9 is a modification example of the cross-sectional view of the phosphor illustrated in Fig. 2;
Fig. 10 is a modification example of the cross-sectional view of the phosphor illustrated in Fig. 3A and another cross-sectional view of the phosphor illustrated in Fig. 9; and
Fig. 11 is a modification example of the cross-sectional view of the phosphor illustrated in Fig. 2.

### DETAILED DESCRIPTION OF THE PREFERRED EMBODIMENTS

Hereinafter, the invention will be described in detail in the following order based on specific embodiments.
1. First Embodiment
   1-1. Light Source Device
      1-1-1. Blue Light Emitting Element
      1-1-2. Phosphor
   1-2. Phosphor Manufacturing Method
   1-3. Effects of Present Embodiment
2. Second Embodiment
3. Third Embodiment
4. Fourth Embodiment

### 1. First Embodiment

### 1-1. Light Source Device

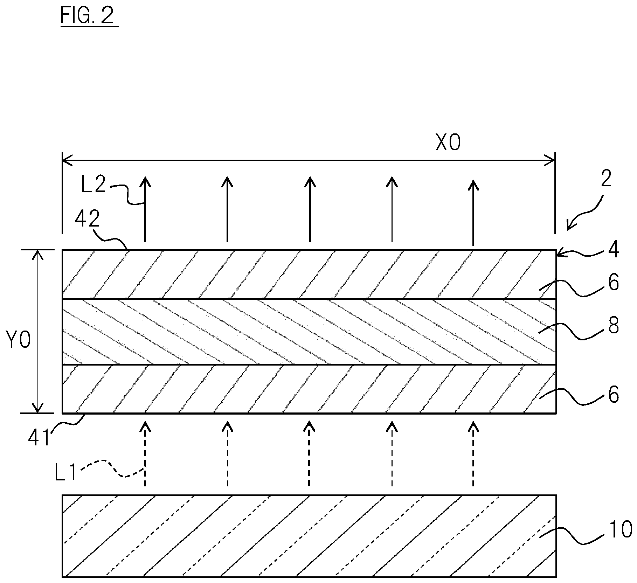

Fig. 2 illustrates a light source device 2 according to the present embodiment. The light source device 2 according to the present embodiment has at least a phosphor 4 according to the present embodiment and a blue light emitting element 10. As illustrated in Fig. 2, in the present embodiment, an air gap is provided between the phosphor 4 and the blue light emitting element 10.

### 1-1-1. Blue Light Emitting Element

As illustrated in Fig. 2, the blue light emitting element 10 emits blue light L1, which is excitation light for exciting the phosphor 4. The blue light L1 of the blue light emitting element 10 usually has a peak wavelength of 425 nm to 475 nm. A part of the blue light L1 incident on a first surface 41 of the phosphor 4 is absorbed by the phosphor 4, is wavelength-converted, and emits fluorescence. The fluorescence emitted in this manner and the blue light L1 are mixed and emit white light L2 from a second surface 42 of the phosphor 4.

The blue light emitting element 10 is not particularly limited insofar as the blue light emitting element 10 is capable of emitting the white light L2 by being mixed with fluorescence and emitting the blue light L1 that can be wavelength-converted into fluorescence by the phosphor 4. Examples of the blue light emitting element 10 include a blue light emitting diode (blue LED) and a blue semiconductor laser (blue LD).

### 1-1-2. Phosphor

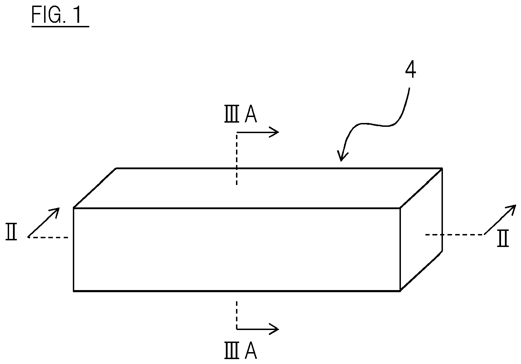

Fig. 1 illustrates the phosphor 4 according to the present embodiment. The phosphor 4 illustrated in Fig. 1 has a rectangular parallelepiped column shape and is a single crystal. Whether the phosphor 4 is a single crystal can be confirmed by, for example, confirming a crystal peak of an αAG single crystal (α represents the following element α) by XRD.

Since the phosphor 4 is a single crystal, the transmittance of the blue light L1 can be improved as compared with transparent ceramics or eutectics. This is because the transmittance of transparent ceramics tends to decrease due to light scattering at grain boundaries and the transmittance of eutectics tends to decrease due to light scattering at phase boundaries. Accordingly, the single crystal phosphor 4 has higher light emission characteristics than transparent ceramics or eutectics.

Although the composition of the phosphor 4 is not particularly limited, the composition has the element α containing at least one of Y and Lu and an element β as an additive and is represented by (α₁₋ₓβₓ)₃₊ₐAl₅₋ₐO₁₂ (0.0001 ≤ x ≤ 0.007, -0.016 ≤ a ≤ 0.315).

Here, the element α may further contain Gd, Tb, or La. In addition, the element α preferably contains at least Y The light emission characteristics can be further improved by the element α containing at least Y

In addition, the element β as an additive is, for example, at least one selected from the group consisting of Ce, Pr, Sm, Eu, Tb, Dy, Tm, and Yb. As a result, light emission characteristics can be imparted. In view of the above, the element β is preferably Ce or Eu and more preferably Ce.

As illustrated in Fig. 2, in the present embodiment, the phosphor 4 has a high concentration region 6 having a high additive concentration and at least one of low concentration regions 8 lower in additive concentration than the high concentration region 6.

The low concentration region 8 is higher in thermal conductivity than the high concentration region 6, that is, higher in heat dissipation than the high concentration region 6. On the other hand, the efficiency of conversion from the blue light L1 to fluorescence is higher in the high concentration region 6 than in the low concentration region 8. Accordingly, since the phosphor 4 has the high concentration region 6, the blue light L1 incident from the first surface 41 of the phosphor 4 is absorbed well and appropriately converted into fluorescence, and thus the light emission characteristics tend to increase.

From the above, the phosphor 4 has the high concentration region 6 having a high additive concentration and at least one of the low concentration regions 8 lower in additive concentration than the high concentration region 6, and thus both the effect of thermal conductivity improvement by means of the low concentration region 8 and the effect of light emission characteristics improvement by means of the high concentration region 6 can be obtained.

It should be noted that the light emission characteristics of the phosphor 4 in the present embodiment are evaluated by a value obtained by multiplying an internal quantum yield value by an excitation light absorption rate. The phosphor 4 of the present embodiment preferably has a light emission characteristic value of 60% or more in the case of an excitation light wavelength of 450 nm.

In addition, since the phosphor 4 of the present embodiment has high thermal conductivity, heat is easily released from the phosphor 4 in a high temperature environment. As a result, it is possible to suppress a thermal quenching phenomenon in which light emission characteristics deteriorate in a high temperature environment.

In addition, since the thermal conductivity of the phosphor 4 is high, heat is easily released from the phosphor 4 and thermal damage to the light source device 2 can be prevented in a case where the phosphor 4 of the present embodiment is used for the light source device 2.

Further, although a rise in temperature may result in a change in the fluorescence wavelength of the phosphor, the phosphor 4 of the present embodiment has high thermal conductivity, and thus heat is easily released from the phosphor 4 and a change in the wavelength of the phosphor 4 attributable to a rise in temperature can be prevented.

In the present embodiment, the low concentration region 8 is preferably a region where the ratio of the amount of the element β to the total amount of the elements α and β (hereinafter, referred to as "element β ratio") is 0.50 mol% or less. Then, the effect of thermal conductivity improvement by means of the low concentration region 8 can be enhanced. From the above viewpoint, the element β ratio in the low concentration region 8 is more preferably 0.01 mol% or more and 0.50 mol% or less and further preferably 0.01 mol% or more and 0.30 mol% or less.

It should be noted that an ultra low concentration region having an element β ratio of less than 0.01 mol% and included in neither the low concentration region 8 nor the high concentration region 6 is present in the phosphor 4 when, for example, the element β ratio of the low concentration region 8 is 0.01 mol% or more. In the present embodiment, the ultra low concentration region may be present in the phosphor 4 in this manner.

In the present embodiment, the high concentration region 6 is a region higher in additive concentration than the low concentration region 8 and other than the low concentration region 8. In addition, the element β ratio in the high concentration region 6 is preferably 0.20 mol% or more. As a result, the effect of light emission characteristics improvement by means of the high concentration region 6 can be enhanced. From the above viewpoint, the element β ratio in the high concentration region 6 is more preferably 0.30 mol% or more.

In addition, in the present embodiment, it is preferable that the difference between the element β ratio in the high concentration region 6 and the element β ratio in the low concentration region 8 is 0.20 mol% or more. Then, the thermal conductivity of the phosphor 4 can be further increased and the light emission characteristics can be further enhanced. From the above viewpoint, the difference between the element β ratio in the high concentration region 6 and the element β ratio in the low concentration region 8 is more preferably 0.30 mol% or more.

It should be noted that the range where the element β ratio exceeds 0.10 mol% and is less than 0.30 mol% is an intermediate concentration region higher in element β ratio than the low concentration region 8 and lower in element β ratio than the high concentration region 6 in a case where, for example, the element β ratio of the low concentration region 8 is 0.10 mol% or less and the element β ratio in the high concentration region 6 is 0.30 mol% or more. In the present embodiment, the intermediate concentration region may be present in the phosphor 4 in this manner.

As illustrated in Fig. 2, in the present embodiment, the high concentration region 6 surrounds at least one of the low concentration regions 8 in the cross-section of the phosphor 4 parallel to the longitudinal direction of the phosphor 4. In addition, in the present embodiment, the cross-section of the phosphor 4 illustrated in Fig. 2 is parallel to the optical path of the blue light L1 transmitted through the phosphor 4. In this manner, in the present embodiment, the high concentration region 6 surrounds at least one of the low concentration regions 8 in a cross-section parallel to the optical path of the blue light L1 transmitted through the phosphor 4.

It should be noted that the cross-section of the phosphor 4 parallel to the longitudinal direction of the phosphor 4 may be different from the cross-section parallel to the optical path of the blue light L1 transmitted through the phosphor 4 although the two cross-sections are the same in Fig. 2.
"the high concentration region 6 surrounds at least one of the low concentration regions 8" means that the entire periphery of at least one of the low concentration regions 8 does not need to be surrounded by the high concentration region 6 and at least the high concentration region 6 may be positioned so as to sandwich at least one of the low concentration regions 8 as illustrated in Fig. 2. Accordingly, a part where the low concentration region 8 is not surrounded by the high concentration region 6 may be partially present with the low concentration region 8 exposed on the surface of the phosphor 4 in a longitudinal end portion as illustrated in Fig. 2.

It should be noted that the high concentration region 6 relatively low in thermal conductivity is present in the crystal in a state where the low concentration region 8 surrounds the high concentration region 6, and thus heat is capable of being internal to the crystal and accumulating.

On the other hand, in a state where the high concentration region 6 surrounds the low concentration region 8, the low concentration region 8 relatively high in thermal conductivity is present in the crystal, and thus heat is internal to the crystal and it is difficult for heat to accumulate, which results in a configuration excellent in heat dissipation in a case where the crystal is viewed as a whole.

Although the size of the phosphor 4 in the present embodiment is not particularly limited, it is preferable that the length in a lengthwise direction Y0 parallel to the optical path of the blue light L1 transmitted through the phosphor 4 is equal to or less than the spot diameter of the incident light. Then, it is possible to prevent the phosphor from being damaged by stress caused by local heating. In addition, the length in a lateral direction X0 perpendicular to the optical path of the blue light L1 transmitted through the phosphor 4 is 100 µm or more. As a result, excitation light can be efficiently absorbed.

It should be noted that the location where the low concentration region 8 is exposed in the phosphor 4 is not limited and the low concentration region 8 may be exposed on the surface of the phosphor 4 in a widthwise direction end portion although the low concentration region 8 is exposed on the surface of the phosphor 4 in a longitudinal end portion in Fig. 2. Heat dissipation is further improved and a rise in the temperature of the phosphor 4 can be further suppressed by the low concentration region 8 being exposed on the surface of the phosphor 4. Since a rise in the temperature of the phosphor 4 can be further suppressed as described above, thermal quenching resistance can be further improved, thermal damage to the light source device 2 can be further prevented, and a change in the wavelength of the phosphor 4 can be further prevented.

In addition, in a case where the phosphor 4 has the ultra low concentration region in the present embodiment, "the high concentration region 6 surrounds at least one of the low concentration regions 8" even when the high concentration region 6 surrounds at least one of the low concentration regions 8 via the ultra-low concentration region.

Likewise, in a case where the phosphor 4 has the intermediate concentration region in the present embodiment, "the high concentration region 6 surrounds at least one of the low concentration regions 8" even when the high concentration region 6 surrounds at least one of the low concentration regions 8 via the intermediate concentration region.

As illustrated in Fig. 2, in the present embodiment, at least one of the low concentration regions 8 may penetrate the phosphor 4 in the longitudinal direction in the cross-section of the phosphor 4 parallel to the longitudinal direction of the phosphor 4. Alternatively, in the cross-section of the phosphor 4 parallel to the optical path of the blue light L1 transmitted through the phosphor 4, at least one of the low concentration regions 8 may penetrate the phosphor 4 along the vertical direction of the optical path of the blue light L1 transmitted through the phosphor 4.

The first surface 41 of the phosphor 4 is a light receiving portion, and the temperature of the first surface 41 tends to increase. Accordingly, by the phosphor 4 being a configuration penetrated by the low concentration region 8, the heat of the first surface 41 can be efficiently conducted to the second surface 42 and dissipated and a rise in the temperature of the phosphor 4 can be further suppressed. Since a rise in the temperature of the phosphor 4 can be further suppressed as described above, thermal quenching resistance can be further improved, thermal damage to the light source device 2 can be further prevented, and a change in the wavelength of the phosphor 4 can be further prevented.

In the present embodiment, two or more low concentration regions 8 may be present in a divided manner or two to 10 low concentration regions 8 may be present in a divided manner in "the cross-section of the phosphor 4 parallel to the longitudinal direction of the phosphor 4" or "the cross-section of the phosphor 4 parallel to the optical path of the blue light L1 transmitted through the phosphor 4". It should be noted that the cross-sectional area of each of the divided low concentration regions 8 is preferably 0.5% or more and 90% or less of the cross-sectional area of "the cross-section of the phosphor 4 parallel to the longitudinal direction of the phosphor 4" or "the cross-section of the phosphor 4 parallel to the optical path of the blue light L1 transmitted through the phosphor 4".

Heat dissipation is further improved and a rise in the temperature of the phosphor 4 can be further suppressed since the low concentration region 8 is present in a divided manner in the phosphor 4. Since a rise in the temperature of the phosphor 4 can be further suppressed as described above, thermal quenching resistance can be further improved, thermal damage to the light source device 2 can be further prevented, and a change in the wavelength of the phosphor 4 can be further prevented.

In the present embodiment, the shape of the low concentration region 8 in the cross-section of the phosphor 4 parallel to the longitudinal direction of the phosphor 4 is not particularly limited, and the shape may be a polygonal shape such as a quadrangular shape or a circular shape. Likewise, the shape of the low concentration region 8 in the cross-section of the phosphor 4 parallel to the optical path of the blue light L1 transmitted through the phosphor 4 is not particularly limited, and the shape may be a polygonal shape such as a quadrangular shape or a circular shape.

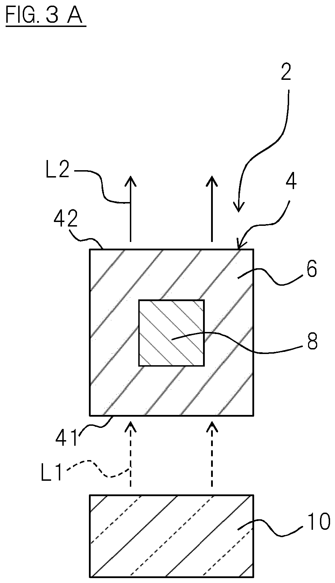

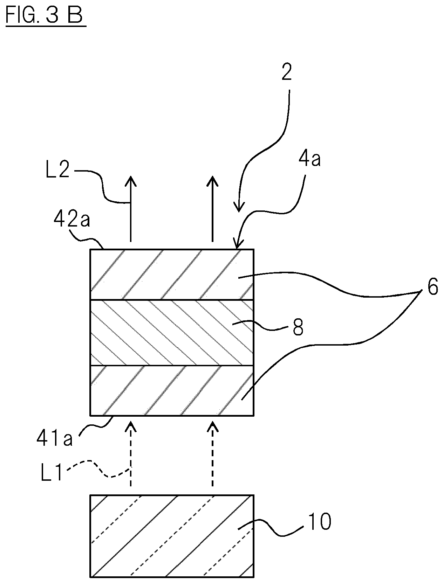

The distribution of the low concentration region 8 and the high concentration region 6 in the widthwise cross-section of the phosphor 4 parallel to the widthwise direction of the phosphor 4 of the present embodiment is not particularly limited. The entire periphery of the low concentration region 8 may be surrounded by the high concentration region 6 as illustrated in Fig. 3A or a widthwise direction end portion of the phosphor 4 may have a part where the low concentration region 8 is not surrounded by the high concentration region 6 as illustrated in Fig. 3B.

In the present embodiment, two or more low concentration regions 8 may be present in a divided manner or two to 10 low concentration regions 8 may be present in a divided manner in the widthwise cross-section. It should be noted that the cross-sectional area of each of the divided low concentration regions 8 is preferably 0.5% or more and 90% or less of the cross-sectional area of the widthwise cross-section.

In the present embodiment, it is preferable that the ratio of the cross-sectional area of the low concentration region 8 in the widthwise cross-section to the cross-sectional area of the widthwise cross-section illustrated in Fig. 3A or 3B (hereinafter, referred to as "low concentration area ratio") is 10% or more and 90% or less. Then, the effect of thermal conductivity improvement by means of the low concentration region 8 and the effect of light emission characteristics improvement by means of the high concentration region 6 can be obtained in a well-balanced manner. From the above viewpoint, the low concentration area ratio is more preferably 10% or more and 80% or less.

It should be noted that the ratio of "the total cross-sectional area of the low concentration regions 8 in the widthwise cross-section" to the cross-sectional area of the widthwise cross-section is "low concentration area ratio" in a case where the low concentration region 8 is divided as described above.

The shape of the low concentration region 8 in the widthwise cross-section of the present embodiment is not particularly limited, and the shape may be a polygonal shape such as a quadrangular shape or a circular shape.

It should be noted that the additive concentration of the phosphor 4 can be measured by LA-ICP-MS, EPMA, EDX, or the like.

### 1-2. Phosphor Manufacturing Method

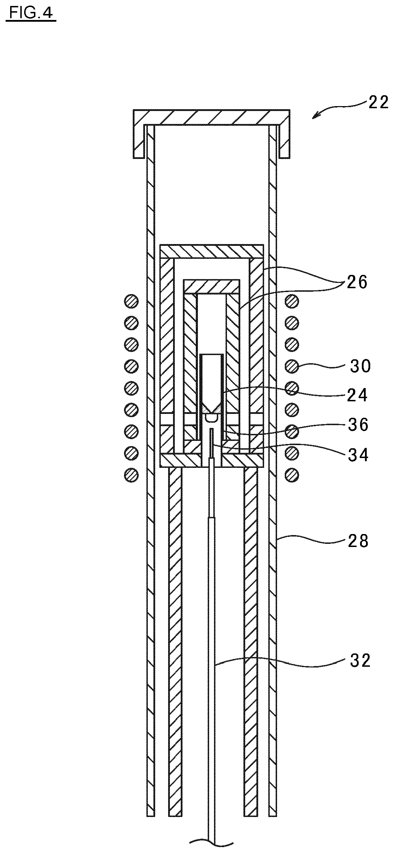

Fig. 4 is a schematic cross-sectional view of a single crystal manufacturing apparatus 22 based on a micro pull-down method (µ-PD method), which is an apparatus for manufacturing the phosphor 4 of the present embodiment. In the µ-PD method, which is a melt solidification method, the melt of a target substance is obtained in a crucible 24 by the sample-containing crucible 24 being directly or indirectly heated. Then, a seed crystal 34 installed below the crucible 24 is brought into contact with an opening portion at the lower end of the crucible 24. The seed crystal 34 is pulled down while a solid-liquid interface is formed there, and a single crystal is grown as a result.

In the melt solidification method, the single crystal grows while an additive moves to a low-temperature location. When individual parts are cut out from the generated single crystal, the phosphor 4 having a predetermined concentration distribution of the additive is obtained at each cutting position. In the µ-PD method in particular, the direction in which the seed crystal 34 is pulled down coincides with the lateral direction of the phosphor 4 (X0 direction). In other words, the direction in which the seed crystal 34 is pulled down coincides with the vertical direction of the optical path of the blue light L1 transmitted through the phosphor 4.

Since the phosphor 4 according to the present embodiment is generated by the µ-PD method, the phosphor 4 is more likely to have the predetermined concentration distribution of the additive than the phosphor of the related art generated by the Czochralski method (CZ method). Specifically, the phosphor 4 has a tendency that the high concentration region 6 easily surrounds the low concentration region 8. Accordingly, it is preferable that the phosphor 4 according to the present embodiment is generated by the µ-PD method.

As illustrated in Fig. 4, the single crystal manufacturing apparatus 22 for manufacturing the phosphor 4 according to the present embodiment includes the crucible 24 installed such that the opening portion is directed downward and a refractory furnace 26 surrounding the crucible 24. Further, the refractory furnace 26 is covered with a quartz tube 28, and an induction heating coil 30 for heating the crucible 24 is installed near the lengthwise center of the quartz tube 28.

The seed crystal 34 held by a seed crystal holding jig 32 is installed in the opening portion of the crucible 24. In addition, an after heater 36 is installed near the opening portion of the crucible 24.

It should be noted that the single crystal manufacturing apparatus 22 is provided with decompression means (not illustrated) for decompressing the inner portion the refractory furnace 26, pressure measuring means (not illustrated) for monitoring the decompression, temperature measuring means (not illustrated) for measuring the temperature of the refractory furnace 26, and gas supply means (not illustrated) for supplying an inert gas into the refractory furnace 26.

A single crystal cut into a rod shape is used as the seed crystal 34. The seed crystal 34 is preferably an additive-free αAG single crystal (α represents an α element).

The material of the seed crystal holding jig 32 is not particularly limited. Preferable is, for example, dense alumina having little effect at around 1,900°C as a use temperature. The shape and size of the seed crystal holding jig 32 are not particularly limited. Preferable is a rod shape with a diameter resulting in no contact with the refractory furnace 26.

The melting point of the single crystal is high, and thus the material of the crucible 24 and the after heater 36 is preferably Ir, Mo, or the like. In addition, it is more preferable to use Ir as the material of the crucible 24 in order to prevent foreign matter from contaminating the single crystal as a result of oxidation of the material of the crucible 24. It should be noted that Pt can be used as the material of the crucible 24 in a case where a substance having a melting point of 1,500°C or less is a target. In addition, crystal growth in the atmosphere is possible in a case where Pt is used as the material of the crucible 24. In a case where a substance having a high melting point exceeding 1,500°C is a target, Ir or the like is used as the material of the crucible 24 and the after heater 36, and thus crystal growth is performed only in an atmosphere of an inert gas such as Ar.

It is preferable that the opening portion of the crucible 24 has a diameter of approximately 200 µm to 400 µm and a flat shape from the viewpoint of the low viscosity of the single crystal melt and wettability with respect to the crucible 24.

Although the material of the refractory furnace 26 is not particularly limited, the material is preferably alumina from the viewpoint of heat retention, use temperature, and prevention of crystal contamination attributable to impurities.

Next, a method for manufacturing the phosphor 4 (single crystal) according to the present embodiment will be described in detail.

First, an αAG raw material (α represents the α element) as a single crystal raw material and the element β as an additive such as Ce are placed in the crucible 24 in the refractory furnace 26, and the inside of the furnace is substituted with an inert gas such as N₂ and Ar.

Next, the crucible 24 is heated by means of the induction heating coil (high frequency coil for heating) 30 while the inert gas flows in at 10 to 100 cm³/min, the raw material is melted, and the melt is obtained.

When the raw material is sufficiently melted, the seed crystal 34 is gradually brought close from the lower portion of the crucible, and the seed crystal 34 is brought into contact with the opening portion at the lower end of the crucible 24. When the melt comes out of the opening portion at the lower end of the crucible 24, the seed crystal 34 is lowered and crystal growth is initiated.

The crystal growth rate is manually controlled, along with the temperature, while the state of the solid-liquid interface is observed by means of a CCD camera or a thermo camera.

By the induction heating coil 30 moving, a temperature gradient can be selected in the range of 10°C/mm to 100°C/mm. In addition, the growth rate of the single crystal can also be selected in the range of 0.01 mm/min to 30 mm/min.

The seed crystal 34 is lowered until the melt in the crucible 24 does not come out and, after the seed crystal 34 is separated from the crucible 24, cooling is performed such that the single crystal does not crack. It is possible to increase the rate of melt withdrawal by setting a steep temperature gradient between the crucible 24 and the after heater 36 and below as described above.

In addition, in the present embodiment, it is possible to obtain the phosphor 4 having a predetermined concentration distribution of the additive by controlling the temperature in the crucible 24 and below by means of the after heater 36. From the above viewpoint, the cooling rate in the crucible 24 and below is preferably 50°C/hour to 900°C/hour.

During the crystal growth and cooling, the inert gas keeps flowing into the refractory furnace 26 under the same conditions as during the heating. It is preferable to use an inert gas such as N₂ and Ar as the atmosphere in the furnace.

### 1-3. Summary of Present Embodiment

In the present embodiment, the phosphor 4 has the high concentration region 6 having a high additive concentration and at least one low concentration region 8 lower in additive concentration than the high concentration region 6. As a result, both the effect of thermal conductivity improvement by means of the low concentration region 8 and the effect of light emission characteristics improvement by means of the high concentration region 6 can be obtained.

In the present embodiment in particular, heat dissipation is improved and a rise in the temperature of the phosphor 4 can be suppressed by the thermal conductivity of the phosphor 4 being improved. Since a rise in the temperature of the phosphor 4 can be suppressed as described above, thermal quenching resistance can be improved, thermal damage to the light source device 2 can be prevented, and a change in the wavelength of the phosphor 4 can be prevented.

Further, in the present embodiment, the phosphor 4 is a single crystal, the phosphor 4 contains the element α by a predetermined amount and the element β as an additive, the additive concentration of the high concentration region 6 and the low concentration region 8 has a predetermined range, and the low concentration area ratio has a predetermined range. Accordingly, the effect of thermal conductivity improvement by means of the low concentration region 8 and the effect of light emission characteristics improvement by means of the high concentration region 6 can be obtained in a more balanced manner.

Such a predetermined concentration distribution of the additive in the phosphor 4 can be obtained by the single crystal that serves as the phosphor 4 being generated by the µ-PD method. In particular, such a predetermined concentration distribution of the additive in the phosphor 4 can be obtained by the after heater 36 controlling the temperature in the crucible 24 and below.

### 2. Second Embodiment

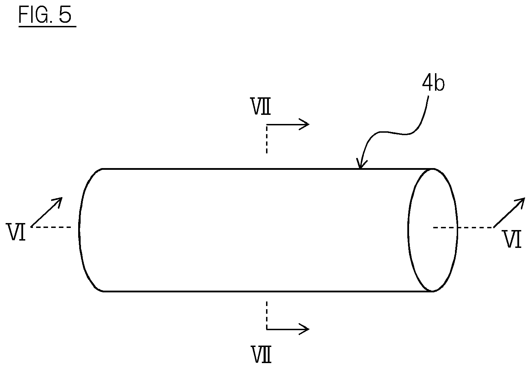

As illustrated in Fig. 5, a phosphor 4b according to the present embodiment is the same as the phosphor 4 of the first embodiment except for the following. The phosphor 4b according to the present embodiment has a columnar shape.

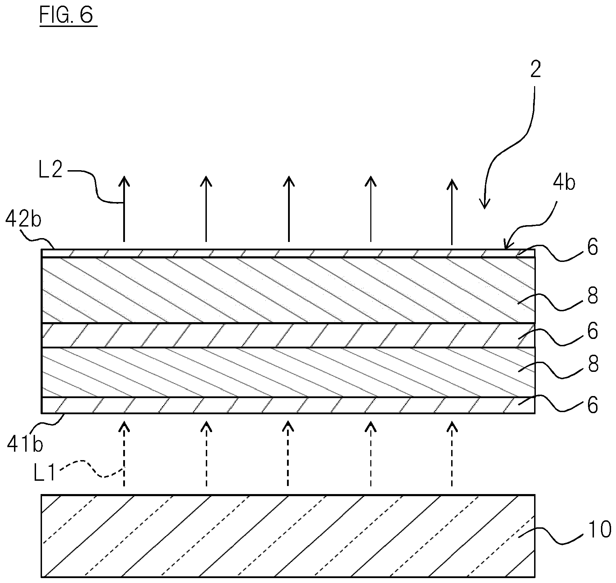

As illustrated in Fig. 6, in the present embodiment, the high concentration region 6 surrounds at least one of the low concentration regions 8 in the cross-section of the phosphor 4b parallel to the longitudinal direction of the phosphor 4b. In addition, in the present embodiment, the cross-section of the phosphor 4b illustrated in Fig. 6 is parallel to the optical path of the blue light L1 transmitted through the phosphor 4b. In this manner, in the present embodiment, the high concentration region 6 surrounds at least one of the low concentration regions 8 in a cross-section parallel to the optical path of the blue light L1 transmitted through the phosphor 4b.

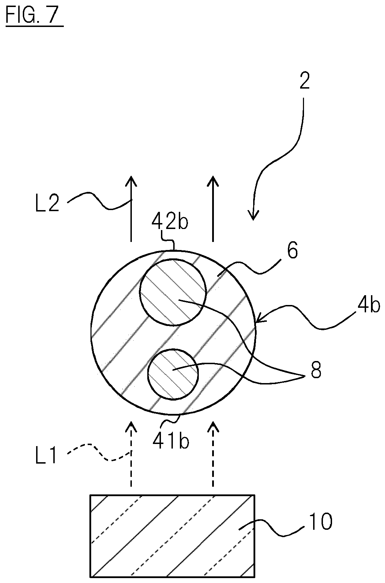

The distribution of the low concentration region 8 and the high concentration region 6 in the widthwise direction cross-section of the phosphor 4b of the present embodiment is not particularly limited. For example, the entire periphery of two low concentration regions 8 may be surrounded by the high concentration region 6 as illustrated in Fig. 7 or a widthwise direction end portion of the phosphor may have a part where the low concentration region 8 is not surrounded by the high concentration region 6.

### 4. Fourth Embodiment

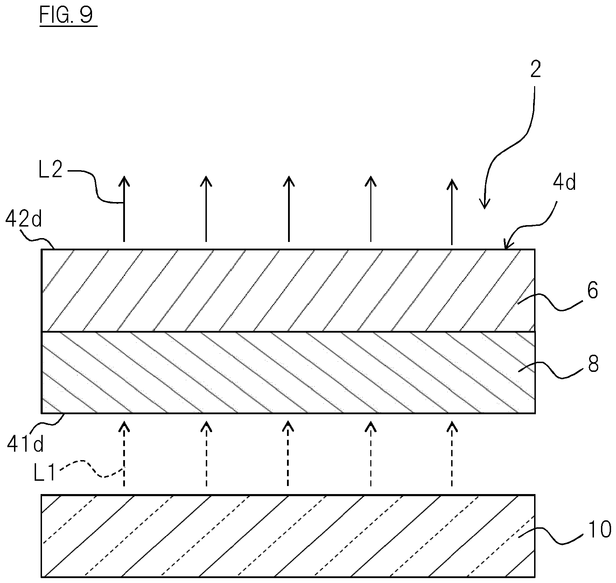

As illustrated in Fig. 9, a phosphor 4d according to the present embodiment is the same as the phosphor 4 of the first embodiment and the phosphor 4c of the third embodiment except for the following.

As illustrated in Fig. 9, in the phosphor 4d of the present embodiment, the high concentration region 6 does not surround at least one of the low concentration regions 8 in the cross-section of the phosphor 4d parallel to the longitudinal direction of the phosphor 4d or the cross-section of the phosphor 4d parallel to the optical path of the blue light L1 transmitted through the phosphor 4d.

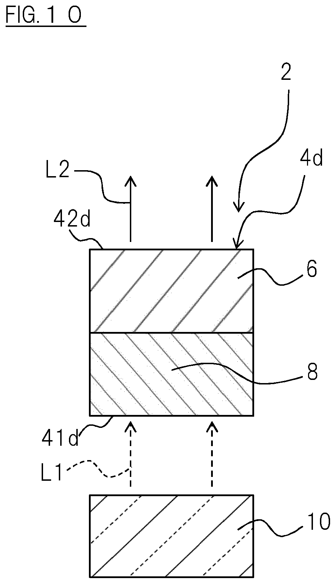

In addition, as illustrated in Fig. 10, the high concentration region 6 does not surround at least one of the low concentration regions 8 also in the widthwise direction cross-section of the phosphor 4d in the phosphor 4d of the present embodiment.

In the optical path cross-section of the phosphor 4d parallel to the direction of the optical path of the blue light L1 transmitted through the phosphor 4d of the present embodiment, the ratio of the cross-sectional area of the low concentration region 8 to the cross-sectional area of the optical path cross-section is preferably 10% or more and 90% or less and more preferably 10% or more and 80% or less. This is for the same reason as why it is preferable that the low concentration area ratio has a predetermined range in the first embodiment.

The invention is not limited to the embodiments described above and can be variously modified within the scope of the invention.

For example, the shape of the phosphor is a columnar shape having a quadrangular cross-section or a columnar shape. The shape may be a polygonal column shape having a non-quadrangular cross-section.

In addition, the predetermined concentration distribution of the additive in the phosphor 4 can also be obtained by EFG method-based growth without being limited to the µ-PD method-based generation of the single crystal serving as the phosphor 4 and the control of the temperature in the crucible 24 and below by means of the after heater 36. It should be noted that the EFG method is a method for growing a crystal by putting a raw material into a crucible, melting the raw material by heating the raw material, bringing this raw material to an opening portion of a slit die installed upright in the crucible, and pulling up a seed crystal in a state where the seed crystal is in contact with the raw material in the opening portion.

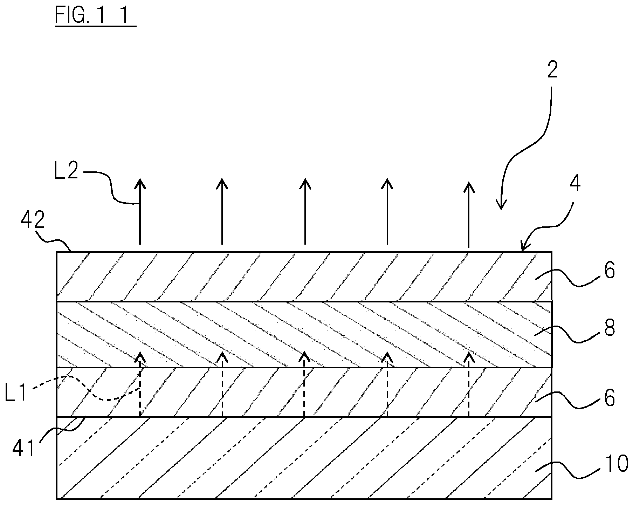

Further, although an air gap is provided between the phosphor 4 and the blue light emitting element 10 in the above description, the phosphor 4 and the blue light emitting element 10 may be in close contact with each other as illustrated in Fig. 11. In addition, a transparent resin may be provided between the phosphor 4 and the blue light emitting element 10.

### Example

Hereinafter, the invention will be described based on more detailed examples, which do not limit the invention.

### (Sample No. 1 to 7 and 12 to 16)

A Ce:YAG single crystal was generated by the µ-PD method and by means of the single crystal manufacturing apparatus 22 illustrated in Fig. 4.

Y₂O₃, Al₂O₃, and CeOz were prepared as starting raw materials, and the crucible 24 made of Ir and having an inner diameter of 16 mm was charged with 2 g of Y₂O₃, Al₂O₃, and CeOz such that Ce became 0.1 mol%. In other words, the type of the element α in Sample No. 1 to 7 and 12 to 16 was Y, and the type of the element β in Sample No. 1 to 7 and 12 to 16 was Ce. At this time, a crucible in which a melt leakage outlet is disposed at the center in a melt exuding surface was used for Sample No. 1 to 7, and a crucible in which a melt leakage outlet is disposed on a slit on one side was used for Sample No. 12 to 16. The refractory furnace 26 was charged with the crucible 24 charged with these raw materials, the atmosphere in the refractory furnace 26 was substituted with N₂, and Nz gas flow was performed at a flow rate of 50 cm³/min with normal pressure maintained.

Subsequently, heating of the crucible 24 was initiated and the crucible 24 was gradually heated for one hour until the melting point of the YAG single crystal was reached.

With the YAG single crystal used as the seed crystal 34, the tip of the seed crystal 34 was brought into contact with the opening portion at the lower end of the crucible 24, the melt having come out of the opening portion was confirmed, and then crystal growth was initiated while the seed crystal 34 was lowered. "Growth rate" is the rate at which the seed crystal 34 was lowered here. At this time, the crystal growth was performed with the growth rate changed in the range of 0.01 mm/min to 0.20 mm/min for each sample. Table 1 shows the growth rate of each sample. It should be noted that it is possible to adjust the distribution of the high concentration region and the low concentration region in the crystal by adjusting the growth rate. The low concentration area tends to increase in a case where the growth rate is low, and the low concentration area ratio decreases in a case where the growth rate is high.

The after heater 36 was installed below the crucible for the purpose of rapid cooling prevention during the above growth. The cooling rate of the crystal, which varies with the crystal growth rate, was adjusted so as to be 70°C/hour to 300°C/hour in this experiment.

As a result, a 2 mm-square Ce:YAG single crystal (phosphor 4) having a columnar shape and a length of 93 mm was obtained. In addition, a columnar Ce:YAG single crystal (phosphor 4) of φ10 mm × t2 mm was also obtained for thermal conductivity and light emission characteristics evaluation.

It should be noted that the crystal peak of phosphor 4 was confirmed by XRD and it was determined that the phosphor 4 is a single crystal in the case of zero foreign phase component content. By this method, it was confirmed that Sample No. 1 to 7 and 12 to 16 are single crystals.

A cross-section parallel to the longitudinal direction was obtained such that the longitudinal thickness of the obtained columnar phosphor 4 became 1 mm. In addition, a widthwise cross-section was obtained such that the widthwise direction thickness of the obtained columnar phosphor 4 became 2 mm. The following observation and measurement were performed in relation to the obtained phosphor 4 or each cross-section of the obtained phosphor 4.

### · Distribution of High Concentration Region 6 and Low Concentration Region 8

Whether or not the high concentration region 6 surrounds the low concentration region 8 and whether or not the low concentration region 8 penetrates the phosphor 4 in the longitudinal direction were confirmed by EDX analysis of the longitudinal cross-section of the obtained phosphor 4. Further, the low concentration area ratio was calculated by EDX analysis of the widthwise cross-section of the obtained phosphor 4. Table 1 shows the results. It should be noted that a region where the element β ratio is 0.50 mol% or less was defined as the low concentration region 8 and a region where the element β ratio exceeds 0.50 mol% was defined as the high concentration region 6.

### · Thermal Conductivity

The room-temperature bulk density of the phosphor 4 was measured by the Archimedes method and with regard to the columnar Ce:YAG single crystal (phosphor 4). In addition, the thermal diffusivity and specific heat of the phosphor 4 were measured by means of xenon flash method thermal diffusivity measuring device TD-1 (produced by ADVANCE RIKO, Inc.). Measurement conditions were as follows.
Temperature (degC): Room temperature
Pulse Width: Long
Sensitivity: Low
DAQ voltage: 5
Sampling Period (ms): 0.05

The thermal conductivity was calculated from the measurement results obtained above. Table 1 shows the results. Table 1 shows a relative value (thermal conductivity ratio) in a case where the thermal conductivity of Sample No. 7 was 100%. Sample No. 7 had a thermal conductivity of 9.5 W/(m-k) to 10.0 W/(m·k).

### · Light Emission Characteristics

The excitation light absorption rate and internal quantum yield of the phosphor 4 were measured under the following conditions with regard to the columnar Ce:YAG single crystal (phosphor 4) and by means of an F-7000 type spectrofluorometer (produced by Hitachi High-Tech Corporation).
Excitation Light Absorption Rate
   Ambient temperature: 25°C
   Measurement mode: excitation spectrum
   Measurement range: excitation wavelength 200 to 800 nm
   Photomal voltage: 400 V
Internal Quantum Yield
   Ambient temperature: 25°C
   Measurement mode: fluorescence spectrum
   Excitation wavelength: 460 nm
   Photomal voltage: 400 V

It should be noted that each characteristic was measured by excitation light being emitted from the surface where the high concentration region of the widthwise direction end surface of the phosphor 4 is exposed. The value obtained by multiplying the measured excitation light absorption rate by the measured internal quantum yield value was defined as "light emission characteristics". Table 1 shows the results. Table 1 shows a relative value (light emission characteristic ratio) in a case where the light emission characteristic of Sample No. 7 was 100%. The light emission characteristic of Sample No. 7 was 60% to 70%.

**[Table 1]**

| Sample No. | Growth rate (mm/min) | Distribution of high concentration region and low concentration region | | | Thermal conductivity ratio (%) | Light emission characteristic ratio (%) | Evaluation result |
|---|---|---|---|---|---|---|---|
| | | High concentration region surrounding low concentration region | Low concentration region penetrating phosphor in longitudinal direction | Low concentration area ratio (%) | | | |
| 1 | 0.010 | - | - | 100 | 132 | 1.6 | C |
| 2 | 0.019 | Yes | Yes | 90 | 129 | 70.0 | B |
| 3 | 0.038 | Yes | Yes | 80 | 126 | 100.0 | A |
| 4 | 0.095 | Yes | Yes | 50 | 116 | 100.0 | A |
| 5 | 0.152 | Yes | Yes | 20 | 106 | 100.0 | A |
| 6 | 0.171 | Yes | Yes | 10 | 103 | 100.0 | A |
| 7 | 0.200 | - | - | 0 | 100 | 100.0 | - |
| 12 | 0.019 | No | | 90 | 129 | 5.0 | C |
| 13 | 0.038 | No | | 80 | 126 | 10.0 | C |
| 14 | 0.095 | No | | 50 | 116 | 40.0 | C |
| 15 | 0.152 | No | | 20 | 106 | 50.0 | C |
| 16 | 0.171 | No | | 10 | 103 | 60.0 | C |

Sample No. 1 to 7 having different low concentration area ratios were obtained by growth rate adjustment. The thermal conductivity and light emission characteristics in Sample No. 7 were set to 100%, and the values of the thermal conductivity and the light emission characteristics regarding Sample No. 1 to 6 were entered as relative values. In the evaluation results in Table 1, A represents a case where the light emission characteristic ratio is 100%, B represents a case where the light emission characteristic ratio is less than 100%, and C represents a case where the light emission characteristic ratio is less than 70%.

Sample No. 1 has a low concentration area ratio of 100%. In this case, only the low concentration region constitutes Sample No. 1, and thus no high concentration region is present although the thermal conductivity ratio is satisfactory. Accordingly, a structure in which the high concentration region surrounds the low concentration region is not employed. Accordingly, the light emission characteristic ratio is remarkably inferior to that of Sample No. 7.

Sample No. 2 to 6 have a structure in which the high concentration region surrounds the low concentration region. Accordingly, Sample No. 2 to 6 are larger in thermal conductivity than Sample No. 7. As for the light emission characteristics, the low concentration area ratio is large, that is, the high concentration area ratio is small in Sample No. 2, and thus Sample No. 2 is in a range allowing use as a product although Sample No. 2 is inferior to Sample No. 7.

As shown in Sample No. 3 to 6, it is possible to obtain light emission characteristics equivalent to the light emission characteristics of Sample No. 7 by further lowering the low concentration area ratio, that is, by increasing the high concentration area ratio.

Assumed from Table 1 is a structure in which the high concentration region is disposed so as to surround the low concentration region, the low concentration region penetrates the phosphor in the longitudinal direction, and the low concentration area ratio is 80% or less. As a result, it was confirmed that the phosphor is particularly excellent in terms of thermal conductivity and light emission characteristics.

In the case of Sample No. 12 to 16, a part of the excitation light may pass only through the low concentration region, where the fluorescence conversion efficiency is low, depending on the irradiation direction of the excitation light. Accordingly, it was confirmed that Sample No. 12 to 16 are inferior in conversion efficiency and light emission characteristic ratio to Sample No. 1 to 7, in which the high concentration region surrounds the low concentration region.

## Claims

1. A columnar phosphor comprising:
a high concentration region; and
at least one of low concentration regions lower in concentration of an additive than the high concentration region,
wherein
the phosphor has an element α and an element β as the additive,
the element α contains at least one of Y and Lu, and
the element β contains at least one selected from the group consisting of Ce, Pr, Sm, Eu, Tb, Dy, Tm, and Yb,
wherein the high concentration region surrounds at least one of low concentration regions in a cross-section of the phosphor parallel to a longitudinal direction of the phosphor, and
at least one of low concentration regions penetrates the phosphor in the longitudinal direction,
wherein "the high concentration region surrounds at least one of low concentration regions" means that the entire periphery of the at least one of the low concentration regions does not need to be fully surrounded by the high concentration region and the high concentration region may be positioned so as to sandwich the at least one of the low concentration regions.

2. The phosphor according to claim 1
wherein the high concentration regions surround at least one of the low concentration regions so as to sandwich them.

3. The phosphor according to claim 2, wherein
the high concentration regions are stacked so as to sandwich at least one of the low concentration regions in a cross-section of the phosphor parallel to a longitudinal direction of the phosphor.

4. The phosphor according to any one of claims 1 to 3, wherein
a ratio of a cross-sectional area of the low concentration regions to a cross-sectional area of a widthwise cross-section is 10% or more and 90% or less in the widthwise cross-section of the phosphor parallel to a widthwise direction of the phosphor.

5. The phosphor according to any one of claims 1 to 4, wherein at least one of the low concentration regions is exposed on a surface of the phosphor.

6. The phosphor according to claim 1, wherein the element α contains at least Y

7. The phosphor according to claim 1 or 6, wherein the element β contains at least Ce.

8. The phosphor according to any one of claims 1, 6 or 7, wherein an element β ratio in the low concentration region is 0.50 mol% or less in which the element β ratio is a ratio of the amount of the element β to a total amount of the element α and the element β.

9. The phosphor according to claim 8, wherein a difference between a ratio of the element β in the high concentration region and a ratio of the element β in the low concentration region is 0.20 mol% or more.

10. The phosphor according to any one of claims 1 to 9, wherein the phosphor is produced by a micro pull-down method.

11. A light source device comprising:
a phosphor; and
a blue light emitting element,
wherein the blue light emitting element is at least one selected from a blue light emitting diode and a blue semiconductor laser,
wherein the phosphor has an element α and an element β as an additive,
the element α contains at least one of Y and Lu, and
the element β contains at least one selected from the group consisting of Ce, Pr, Sm, Eu, Tb, Dy, Tm, and Yb,
the phosphor is columnar,
the phosphor comprises:
a high concentration region; and
at least one of low concentration regions lower in concentration of the additive than the high concentration region,
the high concentration region surrounds at least one of low concentration regions in a cross-section of the phosphor parallel to a direction of an optical path of light transmitted through the phosphor, and
at least one of the low concentration regions penetrates the phosphor along a vertical direction of the optical path
wherein "the high concentration region surrounds at least one of low concentration regions" means that the entire periphery of the at least one of the low concentration regions does not need to be fully surrounded by the high concentration region and the high concentration region may be positioned so as to sandwich the at least one of the low concentration regions.

12. The light source device according to claim 11, wherein a ratio of a crosssectional area of the low concentration region to a cross-sectional area of an optical path cross-section is 10% or more and 90% or less in the optical path cross-section of the phosphor parallel to a direction of an optical path of light transmitted through the phosphor.

13. The light source device according to claim 11 or 12, wherein at least one of the low concentration regions is exposed on a surface of the phosphor.

14. The light source device according to claim 11, wherein the element α contains at least Y

15. The light source device according to claim 11 or 14, wherein the element α contains at least Ce.

16. The light source device according to any one of claims 11, 14 or 15, wherein an element β ratio in the low concentration region is 0.50 mol% or less in which the element β ratio is a ratio of the amount of the element β to a total amount of the element α and the element β.

17. The light source device according to claim 16, wherein a difference between a ratio of the element β in the high concentration region and a ratio of the element β in the low concentration region is 0.20 mol% or more.

## Patentansprüche

1. Ein säulenförmiger Leuchtstoff, umfassend:
Ein Bereich mit hoher Konzentration; und
mindestens ein Bereich mit niedriger Konzentration, die eine geringere Konzentration eines Zusatzstoffs aufweist als der Bereich mit hoher Konzentration,
wobei
der Leuchtstoff ein Element α und ein Element β als Zusatzstoff enthält,
das Element α mindestens eines der Elemente Y und Lu enthält, und
das Element β mindestens ein Element enthält, das aus der Gruppe bestehend aus Ce, Pr, Sm, Eu, Tb, Dy, Tm und Yb ausgewählt ist,
wobei der Bereich mit hoher Konzentration mindestens einen der Bereiche mit niedriger Konzentration in einem Querschnitt des Leuchtstoffs parallel zu einer Längsrichtung des Leuchtstoffs umgibt, und
mindestens einer der Bereiche mit niedriger Konzentration den Leuchtstoff in der Längsrichtung durchdringt,
wobei "der Bereich mit hoher Konzentration umgibt mindestens einen der Bereiche mit niedriger Konzentration" bedeutet, dass nicht der gesamte Umfang des mindestens einen Bereiches mit niedriger Konzentration vollständig von dem Bereich mit hoher Konzentration umgeben sein muss und der Bereich mit hoher Konzentration so angeordnet sein kann, dass er den mindestens einen Bereich mit niedriger Konzentration sandwichartig einschließt.

2. Der Leuchtstoff nach Anspruch 1,
wobei die Bereiche mit hoher Konzentration mindestens einen der Bereiche mit niedriger Konzentration so umgeben, dass sie ihn sandwichartig einschließen.

3. Der Leuchtstoff nach Anspruch 2, wobei
die Bereiche mit hoher Konzentration so gestapelt sind, dass sie mindestens einen der Bereiche mit niedriger Konzentration in einem Querschnitt des Leuchtstoffs parallel zu einer Längsrichtung des Leuchtstoffs sandwichartig einschließen.

4. Der Leuchtstoff nach einem der Ansprüche 1 bis 3, wobei
ein Verhältnis einer Querschnittsfläche der Bereiche mit niedriger Konzentration zu einer Querschnittsfläche eines Querschnitts in Breitenrichtung 10 % oder mehr und 90 % oder weniger in dem Querschnitt in Breitenrichtung des Leuchtstoffs parallel zu einer Breitenrichtung des Leuchtstoffs beträgt.

5. Der Leuchtstoff nach einem der Ansprüche 1 bis 4, wobei mindestens einer der Bereiche mit niedriger Konzentration auf einer Oberfläche des Leuchtstoffs freiliegt.

6. Der Leuchtstoff nach Anspruch 1, wobei das Element α mindestens Y enthält.

7. Der Leuchtstoff nach Anspruch 1 oder 6, wobei das Element β mindestens Ce enthält.

8. Der Leuchtstoff nach einem der Ansprüche 1, 6 oder 7, wobei der Anteil des Elements β im Bereich mit niedriger Konzentration 0,50 Mol-% oder weniger beträgt, wobei der Anteil des Elements β das Verhältnis der Menge des Elements β zur Gesamtmenge des Elements α und des Elements β ist.

9. Der Leuchtstoff nach Anspruch 8, wobei der Unterschied zwischen dem Anteil des Elements β im Bereich mit hoher Konzentration und dem Anteil des Elements β im Bereich mit niedriger Konzentration 0,20 Mol-% oder mehr beträgt.

10. Der Leuchtstoff nach einem der Ansprüche 1 bis 9, wobei der Leuchtstoff durch ein Mikro-Pull-Down-Verfahren hergestellt wird.

11. Eine Lichtquellenvorrichtung, die Folgendes umfasst:
einen Leuchtstoff; und
ein blaues Licht emittierendes Element,
wobei das blaues Licht emittierende Element mindestens eines ist, das aus einer blauen lichtemittierenden Diode und einem blauen Halbleiterlaser ausgewählt ist,
wobei der Leuchtstoff ein Element α und ein Element β als Zusatzstoff enthält,
das Element α mindestens eines der Elemente Y und Lu enthält, und
das Element β mindestens ein Element enthält, das aus der Gruppe bestehend aus Ce, Pr, Sm, Eu, Tb, Dy, Tm und Yb ausgewählt ist,
der Leuchtstoff säulenförmig ist,
wobei der Leuchtstoff umfasst:
einen Bereich mit hoher Konzentration; und
mindestens einen Bereich mit niedriger Konzentration, in denen die Konzentration des Zusatzstoffs niedriger ist als in dem Bereich mit hoher Konzentration,
der Bereich mit hoher Konzentration mindestens einen der Bereiche mit niedriger Konzentration in einem Querschnitt des Leuchtstoffs parallel zu einer Richtung des optischen Wegs des durch den Leuchtstoff übertragenen Lichts umgibt, und
mindestens einer der Bereiche mit niedriger Konzentration den Leuchtstoff entlang einer vertikalen Richtung des optischen Weges durchdringt
wobei "der Bereich mit hoher Konzentration umgibt mindestens einen der Bereiche mit niedriger Konzentration" bedeutet, dass der gesamte Umfang des mindestens einen Bereichs mit niedriger Konzentration nicht vollständig von dem Bereich mit hoher Konzentration umgeben sein muss und der Bereich mit hoher Konzentration so angeordnet sein kann, dass er den mindestens einen Bereich mit niedriger Konzentration sandwichartig einschließt.

12. Die Lichtquellenvorrichtung nach Anspruch 11, wobei das Verhältnis einer Querschnittsfläche des Bereichs mit niedriger Konzentration zu einer Querschnittsfläche eines optischen Pfadquerschnitts 10 % oder mehr und 90 % oder weniger in dem optischen Pfadquerschnitt des Leuchtstoffs parallel zu einer Richtung eines optischen Pfads von durch den Leuchtstoff übertragenem Licht beträgt.

13. Die Lichtquellenvorrichtung nach Anspruch 11 oder 12, wobei mindestens einer der Bereiche mit niedriger Konzentration auf einer Oberfläche des Leuchtstoffs freiliegt.

14. Die Lichtquellenvorrichtung nach Anspruch 11, wobei das Element α mindestens Y enthält.

15. Die Lichtquellenvorrichtung nach Anspruch 11 oder 14, wobei das Element α mindestens Ce enthält.

16. Die Lichtquellenvorrichtung nach einem der Ansprüche 11, 14 oder 15, wobei der Anteil des Elements β im Bereich mit niedriger Konzentration 0,50 Mol-% oder weniger beträgt, wobei der Anteil des Elements β ein Verhältnis der Menge des Elements β zu einer Gesamtmenge des Elements α und des Elements β ist.

17. Die Lichtquellenvorrichtung nach Anspruch 16, wobei der Unterschied zwischen dem Anteil des Elements β im Bereich mit hoher Konzentration und dem Anteil des Elements β im Bereich mit niedriger Konzentration 0,20 mol% oder mehr beträgt.

## Revendications

1. Luminophore colonnaire comprenant :
une région de concentration élevée ; et
au moins une des régions de faible concentration dont la concentration d'un additif est inférieure à celle de la région de concentration élevée,
le luminophore ayant un élément α et un élément β comme additif,
l'élément α contenant au moins un élément parmi Y et Lu, et
l'élément β contenant au moins un élément choisi dans le groupe constitué de Ce, Pr, Sm, Eu Tb, Dy, Tm et Yb,
la région de concentration élevée entourant au moins une des régions de faible concentration dans une section transversale du luminophore parallèle à une direction longitudinale du luminophore, et
au moins une des régions de faible concentration pénétrant dans le luminophore dans la direction longitudinale,
« la région de concentration élevée entourant au moins une des régions de faible concentration » signifiant que la périphérie entière de l'au moins une des régions de faible concentration n'a pas besoin d'être entièrement entourée par la région de concentration élevée et la région de concentration élevée peut être positionnée de manière à prendre en sandwich l'au moins une des régions de faible concentration.

2. Luminophore selon la revendication 1,
les régions de concentration élevée entourant au moins une des régions de faible concentration de manière à les prendre en sandwich.

3. Luminophore selon la revendication 2,
les régions de concentration élevée étant empilées de manière à prendre en sandwich au moins une des régions de faible concentration dans une section transversale du luminophore parallèle à une direction longitudinale du luminophore.

4. Luminophore selon l'une quelconque des revendications 1 à 3,
le rapport entre l'aire de la section transversale des régions de faible concentration et l'aire de la section transversale dans le sens de la largeur étant de 10 % ou plus et de 90 % ou moins dans la section transversale dans le sens de la largeur du luminophore parallèle à la direction de la largeur du luminophore.

5. Luminophore selon l'une quelconque des revendications 1 à 4, au moins une des régions de faible concentration étant exposée sur une surface du luminophore.

6. Luminophore selon la revendication 1, l'élément α contenant au moins Y.

7. Luminophore selon la revendication 1 ou 6, l'élément β contenant au moins Ce.

8. Luminophore selon l'une quelconque des revendications 1, 6 ou 7, un rapport d'élément β dans la région de faible concentration étant de 0,50 % en moles ou moins, le rapport d'élément β étant un rapport de la quantité de l'élément β sur une quantité totale de l'élément α et de l'élément β.

9. Luminophore selon la revendication 8, une différence entre un rapport de l'élément β dans la région de concentration élevée et un rapport de l'élément β dans la région de faible concentration étant de 0,20 % en moles ou plus.

10. Luminophore selon l'une quelconque des revendications 1 à 9, le luminophore étant produit par un procédé de micro pull-down.

11. Dispositif de source lumineuse comprenant :
un luminophore ; et
un élément émetteur de lumière bleue,
l'élément émetteur de lumière bleue étant au moins un élément choisi parmi une diode émettrice de lumière bleue et un laser à semi-conducteur bleu,
le luminophore ayant un élément α et un élément β en tant qu'additif, l'élément β contenant au moins un élément parmi Y et Lu, et
l'élément β contenant au moins un élément choisi dans le groupe constitué de Ce, Pr, Sm, Eu, Tb, Dy, Tm et Yb,
le luminophore étant colonnaire,
le luminophore comprenant :
une région de concentration élevée ; et
au moins une des régions de faible concentration dont la concentration de l'additif est inférieure à celle de la région de concentration élevée,
la région de concentration élevée entourant au moins une des régions de faible concentration dans une section transversale du luminophore parallèle à une direction d'un chemin optique de la lumière transmise à travers le luminophore, et
au moins une des régions de faible concentration pénétrant dans le luminophore le long d'une direction verticale du chemin optique, « la région de concentration élevée entourant au moins une des régions de faible concentration » signifiant que la périphérie entière de l'au moins une des régions de faible concentration n'a pas besoin d'être entièrement entourée par la région de concentration élevée et la région de concentration élevée peut être positionnée de manière à prendre en sandwich l'au moins une des régions de faible concentration.

12. Dispositif de source lumineuse selon la revendication 11, un rapport d'une zone de section transversale de la région de faible concentration sur une zone de section transversale d'une section transversale de chemin optique étant de 10 % ou plus et de 90 % ou moins dans la section transversale de chemin optique du luminophore parallèle à une direction d'un chemin optique de la lumière transmise à travers le luminophore.

13. Dispositif de source lumineuse selon la revendication 11 ou 12, au moins une des régions de faible concentration étant exposée sur une surface du luminophore.

14. Dispositif de source lumineuse selon la revendication 11, l'élément α contenant au moins Y.

15. Dispositif de source lumineuse selon la revendication 11 ou 14, l'élément α contenant au moins Ce.

16. Dispositif de source de lumière selon l'une quelconque des revendications 11, 14 ou 15, un rapport d'élément β dans la région de faible concentration étant de 0,50 % en moles ou moins, le rapport d'élément β étant un rapport de la quantité de l'élément β sur une quantité totale de l'élément α et de l'élément β.

17. Dispositif de source lumineuse selon la revendication 16, une différence entre un rapport de l'élément β dans la région de concentration élevée et un rapport de l'élément β dans la région de faible concentration étant de 0,20 % en moles ou plus.
